# EUROPEAN PATENT SPECIFICATION

(11) **EP 1 359 610 B1**
(45) Date of publication and mention of the grant of the patent: **15.04.2009**
(21) Application number: 01272919.0
(22) Date of filing: 28.12.2001
(51) Int. Cl.: H01L 21/205, H01L 21/22, H01L 21/285, H01L 21/00, C23C 16/44, C23C 16/46

(54) **SUBSTRATE HEATING DEVICE**
SUBSTRATHEIZVORRICHTUNG
DISPOSITIF DE CHAUFFAGE DE SUBSTRAT

(30) Priority: 28.12.2000 JP 2000402468; 16.08.2001 JP 2001247048; 18.12.2001 JP 2001384649
(43) Date of publication of application: 05.11.2003
(73) Proprietor: TOKYO ELECTRON LIMITED, Minato-ku Tokyo 107-8481 (JP)
(72) Inventor: SAITO, Tetsuya, c/o Tokyo Electron AT Limited, Nirasaki-shi, Yamanashi 407-0192 (JP); KASAI, Shigeru, c/o Tokyo Electron AT Limited, Nirasaki-shi, Yamanashi 407-0192 (JP)
(74) Representative: Liesegang, Eva
(86) International application number: PCT/JP2001/011652
(87) International publication number: WO 2002/054469

(56) References cited:
- WO-A-95/23428
- WO-A-03/074759
- JP-A- 5 267 193
- US-A- 5 016 567
- US-A- 5 581 874
- US-A- 5 688 331
- US-A- 5 994 674
- PATENT ABSTRACTS OF JAPAN vol. 2000, no. 15, 6 April 2001 (2001-04-06) -& JP 2000 353665 A (KOKUSAI ELECTRIC CO LTD), 19 December 2000 (2000-12-19)

## Description

### TECHNICAL FIELD

The present invention relates to a substrate heating apparatus and a purging method thereof.

### BACKGROUND OF ART

In the manufacturing process of semiconductor devices, a deposition system for forming a film by using a chemical vapor deposition (CVD) method is adopted widely.

The deposition system employs a structure that creates a plasma from a deposit gas introduced into a processing vessel and further forms a film on a substrate mounted on a mount table. The deposition system is equipped with a substrate heating apparatus enabling heating of a substrate mounted on a mount table having heating means, such as heater.

Although the mount table forming a part of the substrate heating apparatus is supported by a supporting structure where feeding means, such as power line, and sensor means, such as thermo couple, are arranged, it is necessary to seal the supporting structure and the processing vessel in vacuum in order to insulate the interior of the processing vessel from an atmosphere.

In processing, the mount table for heating a substrate is maintained in a high-temperature condition of, for example, about 700 °C. Although a sealing member, such as O-ring of relatively low heat resistance, is adopted in a vacuum sealing part between the supporting structure and the processing vessel, it is necessary to maintain a temperature in the vicinity of the vacuum sealing part within a range from about 100 °C to about 180 °C level in order to prevent gas of TiCl₄-family from adhering to the vicinity of the vacuum sealing part in the form of by-product material and also prevent deterioration of the sealing member, such as O-ring, due to a processing gas.

In this way, in the supporting structure for the mount table, there exists a great difference in temperature between the vicinity of the mount table maintained at about 700 °C and the vicinity of the vacuum sealing part maintained at about 150 °C. Accordingly, the conventional supporting structure for the mount table employs an extremely long columnar structure for avoiding its thermal-stress destruction due to the above temperature difference.

However, such a long columnar structure is apt to be weak in mechanical strength and further accompanied with a problem of difficulty to ensure the accuracy of a wafer surface. Additionally, due to the provision of a long heat transmission route, the columnar structure has a problem with difficulty to ensure uniformity of heat for the mount table because heat radiates from the structure through its strut.

Further, in the conventional supporting structure for the mount table, a part including feeding means, such as power line, and sensor means, such as thermo couple, is communicated with the atmosphere directly. There arises a problem that the power lines and the thermo couple may react with oxygen and moisture contained in the atmosphere to their oxidization. As a result, their routes related to the power lines and the thermo are changed in resistance to make it impossible to control the temperatures precisely.

JP-A-2000353665 discloses a substrate heating apparatus having a processing vessel and a boat carrying a number of wafers. The boat is mounted rotatably wherein a rotation suport part is sealed for air tightness, and the rotation support part is cooled with a cooling gas in a separate cooling container. A bearing for use under pressure and high temperature is provided.

Reference is also made to prior art document WO-A-9523428.

In order to solve the above-mentioned problems that the conventional substrate heating apparatus has, an object of the present invention is to provide a substrate heating apparatus with stable structure and which can establish a uniform heating state on the mount table thereby allowing the temperature of a substrate to be controlled precisely, and also a purging method of the substrate heating apparatus.

### DISCLOSURE OF THE INVENTION

In order to solve the above-mentioned problems, a substrate heating apparatus according to claim 1 and a substrate heating apparatus according to claim 15 is provided. Preferred embodiments are further defined in the dependent claims.

Further disclosed herein is a substrate heating apparatus for heating a substrate mounted on a mount table having heating means, in a processing vessel, wherein a supporting structure for supporting the mount table comprises: a supporting part made from a first material to support the mount table thereon; a sealing part made from a second material different from the first material to seal the supporting part and the processing vessel; and a joint part for connecting the supporting part to the sealing part in an airtight manner.

With the constitution mentioned above, by appropriately selecting the first material and the second material of different heat conductivities, it is possible to reduce a heat gradient between the upper part and the lower part of the supporting structure of the mount table. As a result, even if there is a great difference in temperature between the upper part and the lower part of the supporting structure of the mount table, it is possible to shorten the supporting structure of the mount table. Additionally, with the shortened length of the supporting structure of the mount table, it becomes possible to reduce the volume of the apparatus itself, whereby the heat capacity required to the heating means of the apparatus can be reduced.

Then, it is preferable that the sealing part is deformable due to heat stress. With this constitution, it is possible for the sealing part to absorb a distortion due to heat expansion and shrinkage of the apparatus at processing. For example, the above sealing member can be provided with a bellows structure.

Preferably, a heat insulating material is interposed between the supporting part and the processing vessel. With this constitution, since it becomes possible to bring the supporting part and the processing vessel into a thermal-flow condition, the escape of heat can be prevented effectively to allow the heat uniformity of the mount table to be ensured. Further, owing to the prevention of heat escape, it is also possible to reduce an electric power to be inputted.

Further, it is preferable that the heat insulating material is adapted so as to define a height of the support irrespective of heat-stress deformation of the sealing part. With this arrangement, even if the sealing part is deformed due to heat stress, it is possible to maintain the supporting part at a constant height.

Note, in view of making sure of heat resistance of the joint part, it may be formed by an element to join the first material to the second material in diffusion or brazing. Further, if high heat resistance is not required to the joint part, it may be formed by an O-ring.

Further described herein is a substrate heating apparatus for heating a substrate mounted on a mount table having heating means, in a processing vessel, wherein a supporting mechanism for supporting the mount table comprises: a supporting part for supporting the mount table; a heat insulating material interposed between the supporting part and the processing vessel; and a sealing part for sealing the supporting part and the processing vessel. Then, the sealing part can be formed by an O-ring.

For example, if it is not required for the sealing part of the substrate supporting structure to have a very high heat resistance due to the heating process at relatively low (not very high) temperatures, the above-mentioned constitution is applicable to this case suitably.

Further described herein is a substrate heating apparatus for heating a substrate mounted on a mount table having heating means, in a processing vessel, wherein the interior of a supporting structure which supports the mount table and in which power supplying means for the heating means is arranged, is sealed up in an airtight manner.

According to the above-mentioned constitution, as the interior of the supporting structure containing the power supplying means is insulated from the atmosphere, it is possible to prevent the power supplying means from being oxidized. Additionally, even if the supporting structure for mount table is broken partially, it is possible to avoid leakage of a processing gas into the atmosphere.

In the above-mentioned substrate heating apparatus, the exhausting means is arranged to exhaust the interior of the supporting structure to a vacuum. In this constitution, by evacuating the interior of the supporting structure in vacuum, it is possible to remove oxygen and moisture as the origin of oxidation of the power supplying means effectively.

It is preferable that the above substrate heating apparatus is provided with purging means to purge the interior of the supporting structure. With this constitution, for example, owing to the purging of inert gas, it is possible to prevent the power supplying means from being oxidized and also possible to prevent an occurrence of discharging of electricity.

Further described herein is a purging method for a substrate heating apparatus that heats a substrate mounted on a mount table having heating means, in a processing vessel, wherein the interior of a supporting structure which supports the mount table and in which power supplying means for the heating means is arranged, is sealed up in an airtight manner and the substrate heating apparatus further comprises exhausting means for exhausting the interior of the supporting structure to a vacuum and purging means for purging the interior of the supporting structure, the purging method comprising the steps of: exhausting the interior of the supporting structure to a vacuum by the exhausting means; and thereafter, purging the interior of the supporting structure by the purging means.

With the above constitution, by evacuating the interior of the supporting structure in vacuum, it is possible to remove oxygen and moisture as the origin of oxidation of the power supplying means effectively. Further, for example, owing to the purging of inert gas, it is possible to prevent the power supplying means from being oxidized.

According to a preferred embodiment, in the cylindrical supporting part, there is arranged a cable having an end connected to a heater in the mount table and another end wired to the outside through the cover member, and the cable's part passing through the cover member is sealed in an airtight manner.

Also described herein is a substrate heating apparatus comprising a processing vessel, a supporting body arranged in the processing vessel and a plate-shaped mount table supported by the supporting body to mount a wafer thereon for processing, thereby heating and processing a wafer on the mount table, wherein the plate-shaped mount table is provided with a heater wiring pattern embedded in an upper layer of the mount table in a manner of thin film to generate heat and a power-supply wiring pattern in the form of a thin film that supplies an electric power supplied through the supporting body to the heater wiring pattern.

### BRIEF DESCRIPTION OF THE DRAWINGS

Fig. 1 is a schematic sectional view of a substrate heating apparatus applied to a deposit apparatus.
Fig. 2 is an enlarged sectional view of a part of the substrate processing apparatus shown in Fig. 1 in enlargement.
Fig. 3 is an enlarged sectional view of another part of the substrate processing apparatus shown in Fig. 1 in enlargement.
Fig. 4 is a schematic sectional view showing an exhaust system and a purge system of the deposit apparatus shown in Fig. 1 characteristically.
Fig. 5 is a schematic sectional view of a substrate heating apparatus, which is not an embodiment of the present invention, applied to a deposit apparatus.
Fig. 6 is a schematic sectional view of a substrate heating apparatus, which is not an embodiment of the present invention, applied to a deposit apparatus.
Fig. 7 is a schematic sectional view of an embodiment where the substrate heating apparatus of the present invention is applied to a deposit apparatus.
Fig. 8 is a schematic sectional view of an embodiment where the substrate heating apparatus of the present invention is applied to a deposit apparatus.
Fig. 9 is a schematic sectional view of an embodiment where the substrate heating apparatus of the present invention is applied to a deposit apparatus.
Fig. 10 is a schematic sectional view of a mount table.
Fig. 11 is a schematic plan view of a common wiring 608.
Fig. 12 is a schematic plan view of an outer heater 609 and an inner heater 610.
Fig. 13 is a schematic plan view of a common wiring 708.
Fig. 14 is a schematic plan view of an outer heater 709 and an inner heater 710.

### PREFERRED EMBODIMENTS FOR EMBODYING THE INVENTION

Referring to the attached drawings, preferred embodiments of the substrate heating apparatus and the purging method of the present invention will be described. Note, in the following descriptions and the attached drawings, elements having the substantially same function and constitution are indicated with the same reference numerals respectively and their overlapping descriptions are eliminated.

### (1st. Example)

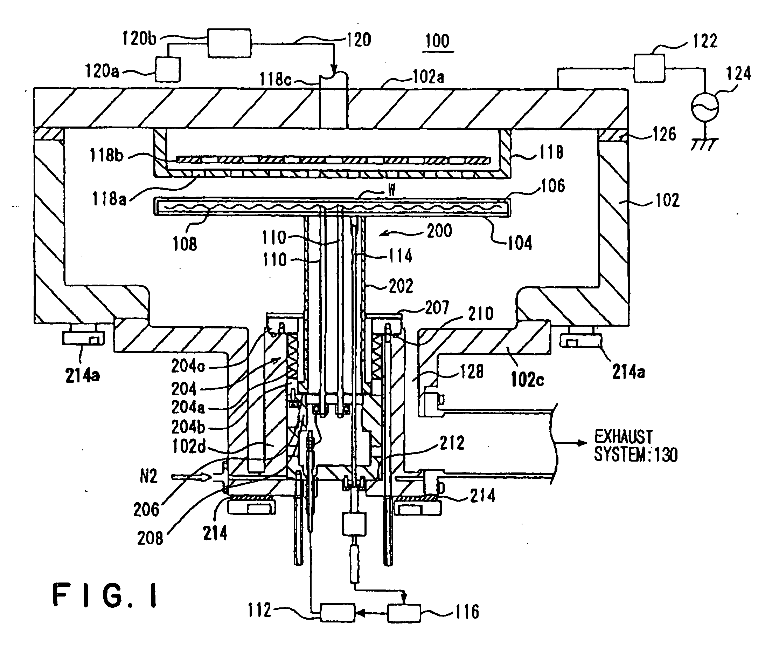

Fig. 1 is a sectional view showing the schematic constitution of a deposit apparatus 100 to which a substrate heating apparatus is applicable. This deposit apparatus 100 has a substantially-cylindrical processing vessel 101 constructed in a gas-tight manner. In the processing vessel 101, a mount table 104 is arranged to horizontally support a substrate (semiconductor wafer) W as an object to be processed. The mount table 104 is supported by a supporting structure 200 in the form of a cylinder. The supporting structure 200 forms a part of the substrate heating apparatus of this embodiment and the detailed constitution of the structure 200 will be described later. The mounting table 104 is provided, on an outer margin thereof, with a guide ring 106 for guiding the semiconductor wafer W.

As heating means forming a part of the substrate heating apparatus of the embodiment, a heater 108 is embedded in the mount table 104. The heater 108 consists of resistance wires of W, Mo, etc. and generates heat by an electric power supplied from a power source 112 through power lines 110 as power supplying means built in the supporting structure 200 to heat the semiconductor wafer W up to a predetermined temperature.

As sensor means, a thermo couple 114 is attached to the mount table 104, detecting a temperature appropriately. A control unit 116 is connected to the power source 112, thereby allowing an output to the heater 108 to be controlled corresponding to the measurement of the thermo couple 114.

On a top wall 102a of the processing vessel 102, a gas introducing mechanism 118 is formed to introduce a deposit gas into the processing vessel 102. The gas introducing mechanism 118 is referred to as the so-called "shower head" whose surface opposed to a processing surface of the semiconductor wafer W mounted on the mount table 104 has a number of gas discharge holes 118a. Note, reference numeral 118b denotes a current plate that rectifies a gas flow introduced from a gas introducing hole 118c into the gas introducing mechanism 118 to allow the gas flow to spout out from the gas discharge holes 118a into the processing vessel 102 uniformly.

A deposit gas supplying system 120 is connected to the gas introducing hole 118c. The deposit gas whose flow rate is controlled by a mass-flow controller 120b and not shown valves is introduced from a gas source 120a into the processing vessel 102. As for the deposit gas, of course, it is possible to adopt a variety of gas corresponding to a process. If giving an example of a process to form a metal wiring layer of e.g. Ti film, TiN film or the like, then N₂ gas, NH₃ gas, H₂ gas, Ar gas, TiCl₄ gas, etc. are used for the deposit gas. In such a case, there will be prepared deposit-gas supplying systems corresponding to these sorts of gases.

A high-frequency power source 124 is connected to the top wall 102a through a matching circuit 122. At processing, a high-frequency power from the high-frequency power source 124 is applied to the top ceiling 102. By the high-frequency power, a deposit gas introduced into the processing vessel 102 is processed to produce a plasma thereby forming a film on the substrate W mounted on the mount table 104. Note, between the top wall 102a of the processing vessel 102 and its side wall 102b, an insulating member 126 is arranged to attain an electrical insulation therebetween.

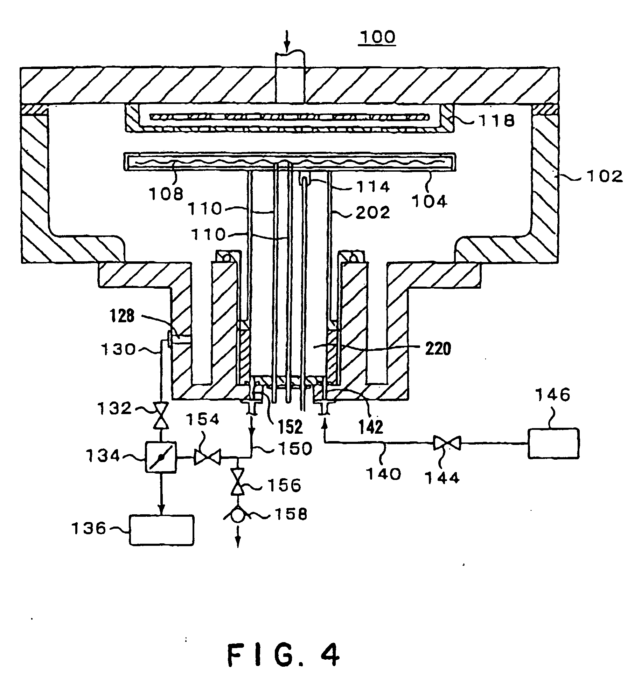

Formed in a bottom part 102c of the processing vessel 102 is an exhaust port 128 to which an exhaust system 130 is connected for exhausting the inside of the processing vessel 102. The detailed constitution of the exhaust system 130 will be described in connection with Fig. 4 later.

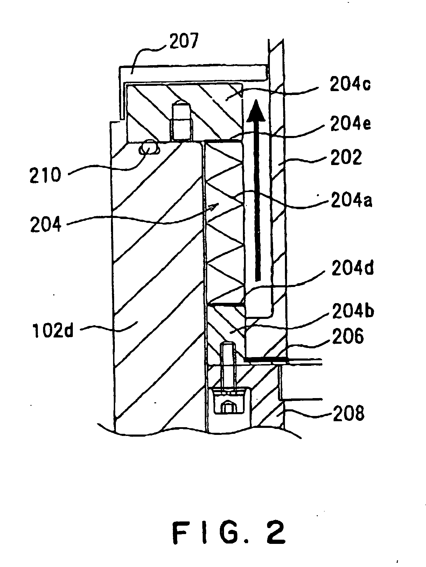

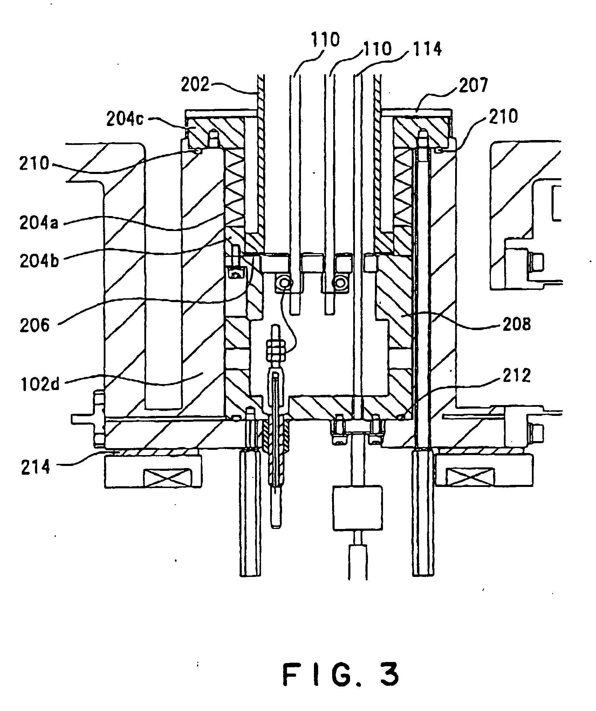

Next, with reference to Figs. 1, 2 and 3, the supporting structure 200 for the mount table 104 of the substrate heating apparatus of the first example will be described in detail. Note, Fig. 2 is an enlarged sectional view showing a joint part of the supporting structure 200 of the substrate heating apparatus of Fig. 1, in enlargement. Fig. 3 is an enlarged sectional view showing a bottom structure of the supporting structure 200 of the substrate heating apparatus of Fig. 1, in enlargement.

The supporting structure 200 includes a substantially-cylindrical supporting part 202 for supporting the mount table 104, a sealing part 204 arranged so as to surround the lower part of the supporting part 202 to seal the supporting part 202 and the processing vessel 102c and a joint part 206 for joining the supporting part 202 and the sealing part 204 in an airtight manner. Further, the supporting part 202 is supported by a heat insulating material 208. The lower part of the supporting structure 200 containing the sealing part 204 and the heat insulating material 208 is accommodated in a supporting-structure storage part 102d in the form of a substantial cylinder formed downward of the processing vessel 102. Thus, the lower part of the supporting structure 200 is constructed so as to reduce the volume of the processing vessel 102.

The supporting part 202 can be made from ceramic material which is superior in plasma-resistance characteristics, for example, Al₂O₃, AlN, SiC, graphite, etc. In the embodiment of Figs. 1 to 3, the sealing part 204 is formed by an extensible bellows 204a made of aluminum, nickel, Hastelloy, etc., a lower flange 204b supporting the bellows 204a from its underside and an upper flange 204c supporting the bellows 204a from its upside. The lower flange 204b and the upper flange 204c are made from the same material as the bellows 204a and further welded to the bellows 204a through welding parts 204d, 204e respectively. As metal contaminants from the bellows are produced between the sealing part 204 and the supporting part 202 as shown with an arrow, the top of the upper flange 204c is covered with a metal-contaminant cover 207 made of alumina, AlN, etc., thereby preventing the leak-out of metal contaminants into a chamber. The heat insulating material 208 is formed by a material, such as alumina, quartz, ceramics or the like.

In this way, in the supporting structure 200 of the first embodiment, the supporting part 202 is formed by a material having a certain measure of rigidity in view of its function to support the mount table 104. While, the sealing part 204 for sealing the processing vessel 102 and the supporting part 202 is formed to have a structure deformable due to heat stress, for example, a bellows structure in the shown example. As for the heat insulating material 208, it is preferable to have a rigidity allowing the supporting structure 200 to be maintained at a regular length even if the sealing part 204 is deformed due to heat stress, as similar to the supporting part 202.

Note, since the interposing of the heat insulating material 208 between the supporting part 202 of the supporting structure 200 and the processing vessel 102 allows the supporting part 202 and the bottom part 102c of the processing vessel 102a to be brought into a thermal-flow condition, it is possible to prevent escape of heat effectively, whereby the heat uniformity of the mount table 104 can be ensured. Further, owing to the prevention of heat escape, it is also possible to reduce an electric power to be inputted.

Here, since the supporting part 202 and the sealing part 204 are formed by different materials respectively, it is possible to adopt sealing means, for example, a thermal diffusion brazing of metal and ceramics having a heat resistance of more than 100 °C, especially more than 170 °C, for the joint part 206 capable of joining the supporting part 202 to the sealing part 204 in an airtight manner. Note, in an application where little heat resistance is required, it goes without saying that sealing means, such as O-ring, can be used as the joint part 206. Fluorinated Calrez and Viton having heat resistance, plasma-proof and corrosion resistance may be used for the O-ring.

Further, the upper flange 204c is sealed to the top of the supporting-structure storage part 102d through an O-ring 210, in an airtight manner. Similarly, the heat insulating material 208 is sealed to the bottom of the supporting-structure storage part 102d by sealing means 212, such as O-ring, in an airtight manner. A Peltier element 214 is interposed on the atmospheric side of the bottom part 102c of the processing vessel 102 and another Peltier element 214a is arranged on the lower part of the processing vessel 102. Thus, by heating the bottom part 102 of the processing vessel 102 and also the lower part of the processing vessel 102 and maintaining their temperatures within a range from 100 to 200 °C, preferably, from 150 to 180 °C, the substrate heating apparatus is adapted so as not to cause separation of reaction by-product, such as NH₄Cl, and liquefaction of reaction gas.

As mentioned above, in the supporting structure 200 of the substrate heating apparatus of this embodiment, the supporting part 202 having a function to support the mount table 104 mainly and the sealing part 204 having functions to seal between the bottom part 102c of the processing vessel 102a and the supporting structure 200 and absorb the change in thermal stress mainly are formed by different bodies of different materials, respectively.

According to the above constitution, since the appropriate selection of materials and dimensions against the supporting part 200 whose top is required to have heat resistance of about 700 °C and also the sealing part 204 whose joint part to the bottom part 102c of the processing vessel 102 is required to have heat resistance of about 150 °C allows a heat gradient between the upper part of the supporting structure 200 of the mount table 104 and the lower part of the same structure to be reduced, it is possible to shorten the length of the supporting structure 10 of the mount table 104.

To reduce a length of the supporting structure 200 of the mount table 104 would allow the capacity of the deposit apparatus 100 itself to be decreased. Especially, if the supporting part 202 and the sealing part 204 are provided in double structure as the substrate heating apparatus of this embodiment, then it is possible to shorten the length of the supporting structure 200 itself furthermore.

Noted that in the supporting structure 200 of the substrate heating apparatus of this embodiment, the supporting part 202 is arranged inside the structure 200 and the sealing part 204 is arranged so as to surround the supporting part 202; nevertheless, it goes without saying that depending on the structure of the processing vessel 102, it is possible to adopt a structure where the supporting part 202 surrounds the outside of the sealing part 204 while arranging the sealing part 204 inside the structure 200.

Next, the structures of the exhaust system 130, a purge-gas exhaust system 150 and a purge-gas supply system 140 of the substrate heating apparatus of this embodiment will be described with reference to Fig. 4.

Note, the sectional view of the deposit apparatus of Fig. 4 generally corresponds to the deposit apparatus of Fig. 1 and also illustrates one example of the exhaust system of purge gas. First, we describe the exhaust system of purge gas. An exhaust port 128 is connected to an exhaust pump 136 through a closing valve 132 and a pressure control valve (APC) 134. When exhausting the interior of the processing vessel 102, the exhaust pump 136 is driven on condition of opening the closing valve 132 interposed in an exhaust pipe 132 to open the pressure control valve 134 fully.

In the substrate heating apparatus of this embodiment, an interior 220 of the supporting structure 200 supporting the mount table 104 is sealed in an airtight manner and insulated from the atmosphere around. However, the interior 220 of the supporting structure 200 is communicated with the purge-gas exhaust system 150 and the purge-gas supply system 140. The purge-gas exhaust system 150 is connected with the exhaust system 150 of the processing vessel 102.

In the supporting structure 200, a purge-gas introducing hole 142 is formed to introduce purge gas, such as inert gas, into the interior 220. This purge-gas introducing hole 142 is connected with a purge-gas source 146 through a purge-gas introducing pipe and a opening/closing valve 144 interposed therein, allowing inert gas, for example, nitrogen, Ar, etc. to be introduced into the interior 220 of the supporting structure 200.

Furthermore, in the supporting structure 200, an exhaust port 152 is formed to communicate with the exhaust system 150 in order to evacuate the interior 220 to a vacuum. Through a opening/closing valve 154, the exhaust system 150 is connected to the pressure control valve 134 interposed in the exhaust system 130 in the processing vessel 102. Further, the exhaust system 150 branches off on the upstream side of the opening/closing valve 154 and communicates with the exhaust system through a closing valve and a check valve 158.

As previously stated, there are the power lines 110 for supplying an electric power to the heater 108 in the mount table 104 and the sensor means, such as the thermo couple 114, in the interior 220 of the supporting structure 200. For that matter, as the conventional apparatus, if the interior of the supporting structure 200 is communicated with the atmosphere, there is the possibility that the power lines 110 and a signal line of the thermo couple 114 are oxidized due to oxygen and moisture contained in the atmosphere. Additionally, if the ceramic supporting part 202 of the supporting structure 200 is broken, then there is the possibility that a processing gas leaks out into the atmosphere through its broken part.

According to the substrate heating apparatus of this embodiment, however, the interior 220 of the supporting structure 200 is sealed in an airtight manner, as a different system from the vacuum sealing form of the supporting structure 200 against the processing vessel 102. Therefore, it is possible to discharge moisture and oxygen as the origins of oxidation of the power lines 110 and the thermo couple 114. Further, even if the ceramic supporting part 202 of the supporting structure 200 is broken, it is possible to avoid an unexpected situation where the processing gas in the processing vessel 102 leaks out into the atmosphere.

Again, since the interior 220 of the supporting structure 200 is filled up with the inert gas, it is possible to prevent the signal lines, such as the power lines 110 and the thermo couple 114, from being oxidized. Additionally, since the interior 220 of the supporting structure 200 is maintained to have a positive pressure, it is possible to prevent occurrence of an electric discharge effectively.

Next, a method of purging the interior 220 of the supporting structure will be described.

First, it is carried out to close the opening/closing valve 144 of the purge system 140 of the supporting structure 200 and the opening/closing valve 156 of the exhaust system 150 about the interior 220 of the supporting structure 200. Then, the opening/closing valve 154 is opened to remove the atmosphere (oxygen, moisture, etc.) contained in the interior 220 of the supporting structure 200 to the utmost, due to the exhaust pump 136.

On completion of the vacuum discharge of the interior 220 of the supporting structure 200, the opening/closing valve 154 of the exhaust system 150 is closed, while the opening/closing valve 156 is opened. Then, by opening the opening/closing valve 144 of the purge system 140, the inert gas, such as nitrogen and argon, is fed from the inert-gas source 146 to the interior 220 of the supporting structure 200. Superfluous inert gas is fed to the exhaust system through the check valve 158 of the exhaust system 150 and subsequently discharged therefrom. After completing the purging of the interior 220 of the supporting structure 200 for a predetermined period, the closing of the opening/closing valve 156 of the exhaust system 150 and the opening/closing valve 144 of the supply system 140 causes the interior 220 of the supporting structure 200 to be filled up with the inert gas, whereby it is possible to prevent the signal lines, such as the power lines 110 and the thermo couple 114 from being oxidized and also possible to prevent occurrence of an electric discharge effectively. Although a purge gas is enclosed in the interior 220 of the supporting structure 200 in the above embodiment, there may be adopted an alternative structure to maintain the interior 220 of the supporting structure 200 in a vacuum state.

Next, the operation of the deposit apparatus constructed above will be described in brief. Giving an example of the process of forming a Ti-film in the above-constructed deposit apparatus, it is first carried out to introduce a semiconductor wafer W into the processing vessel 102. Next, while heating the semiconductor wafer W to a temperature within a range from about 200 °C to about 700 °C by the heater 108, the interior of the processing vessel 102 is evacuated to a high vacuum state, for example, vacuum from about 0.1 Torr to about 10 Torr. Next, a designated deposit gas of a predetermined amount of flowing, for example, H₂-gas and Ar-gas, TiCl₄-gas, etc. are individually introduced into the processing vessel 102 to form a plasma thereby performing the deposit process for a predetermined period. After completing the deposit process, the semiconductor wafer W is unloaded from the processing vessel 102.

Note, at the deposit process of the deposit apparatus of this embodiment, it is necessary that a temperature in the vicinity of the mount table 104 reaches 700 °C and a temperature in the vicinity of the sealing part 204 is at least more than 100 °C, preferably, more than about 170 °C. This is because the deposit gas of a temperature less than 170 °C may cause adhesion of reaction by-product (NH₄Cl) and liquefaction of the deposit gas. According to the embodiment, without making sure of the supporting structure 200 having a sufficient length for the mount table 104, it is possible to accomplish the above difference in temperature in spite of the supporting structure 200 having the minimum length. Further, it is possible to maintain the strength of the mount table 104 so as not to depart from the supporting structure 200 and also possible to control the uniformity in temperature of the mount table 104 appropriately.

For example, in order to make sure of the above-mentioned temperature condition, the conventional deposit apparatus has been required to have its supporting part of about 270 mm in length. However, in case of this embodiment, even if the length of the supporting part is less than 270 mm, the above temperature condition can be ensured, preferably, less than 200 mm. For instance, if aluminum having the heat resistance of 300 °C is employed as the sealing material, the supporting part of about 150 mm in length would be sufficient to make sure of the above temperature condition . Alternatively, if nickel or Hastelloy having the heat resistance ranging from about 400 °C to about 500 °C is employed as the sealing material, the supporting part of about 100 mm in length would be sufficient.

Further, since the interior of the supporting structure 200 in which the power supplying means 110 for the heater 108 in the mount table 104 is arrange is exhausted to a vacuum and is purged by the inert gas, the power supplying means 110 is hard to be oxidized, whereby it is possible to maintain the control against the heater 108 with accuracy.

Noted that the substrate heating apparatus of this embodiment gives a generic name to mechanisms related to the purpose of heating the substrate W mounted on the mount table 104 equipped with the heating means 108 in the processing vessel 104. Additionally, in this embodiment, the supporting structure for the mount table 104 is also contained in the above concept. Nevertheless, the present invention is not limited to the above-mentioned constitution only and therefore, it goes without saying that various constitution can be employed corresponding to the constitution of a processing apparatus that the substrate heating apparatus of this embodiment can apply, for example, a semiconductor manufacturing apparatus, such as deposit apparatus.

### (2nd. Example)

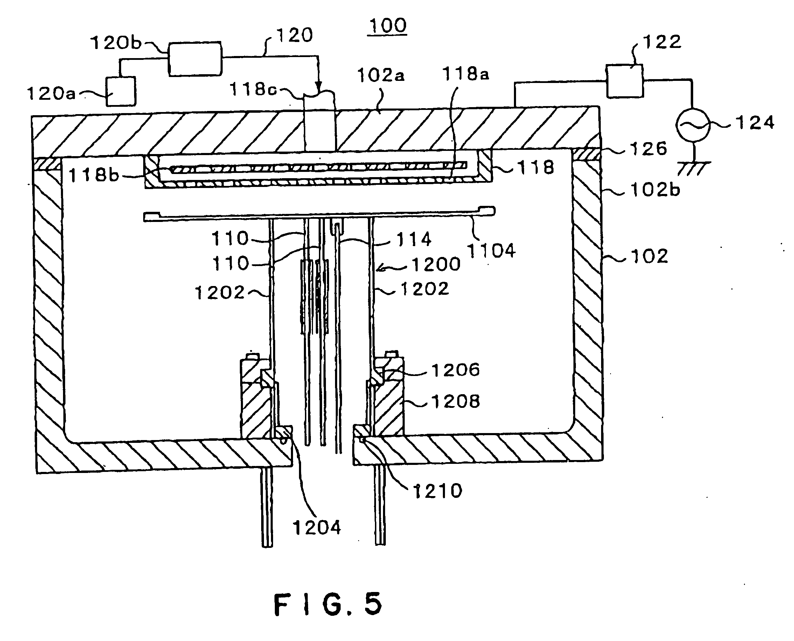

Next, the substrate heating apparatus in accordance with a second example, which is not an embodiment of the present invention, will be described with reference to Fig. 5. Note, in this example, elements similar to those of the substrate heating apparatus of Figs. 1 to 4 in terms of function and constitution are indicated with the same reference numerals respectively and their overlapping descriptions are eliminated.

The difference between the substrate heating apparatus of Fig. 1 and the substrate heating apparatus of Fig. 5 resides in the supporting structures 200, 1200. In the substrate heating apparatus of Fig. 1, the sealing part 204 of the supporting structure 200 is arranged so as to surround the outside of the supporting part 202. On the other hand, in the substrate heating apparatus of Fig. 5, a sealing part 1204 of the supporting structure 1200 is arranged below a supporting part 1200 and also sealed to the processing vessel 102 through sealing means 1210 such as O-ring.

Again, although the processing vessel of the deposit apparatus of Fig. 5 is in the form of a normal barrel, the processing vessel may be provided, on its bottom, with a bucket part where the substrate heating apparatus is arranged.

Additionally, as the interior of the supporting part is opened to the atmosphere, the structure does not require the purge-gas structure as shown in Fig. 4 and therefore, it is possible to accomplish a thermal uniformity structure of simple constitution.

Further, the structure employs a heat insulating material 1208 positioned below the supporting structure 1200 and outside the sealing part 1204. It is preferable that the heat insulating material 1208 is made of ceramics, such as Al₂O₃ and AlN, and has an heat insulating effect. Further, a joint part 1206 for sealing the supporting part 1202 to the sealing part 1204 in an airtight manner is adapted so as to join to the sealing part 1204 inside the supporting part 1202. The sealing part 1204 is made from an element having a low heat conductivity, for example, a metal seal or a bellows pipe of SUS, Hastelloy, Ni alloy or Ni.

In this way, although the supporting structure 200 of the substrate heating apparatus of Fig. 1 differs from the supporting structure 1200 of the substrate heating apparatus of Fig. 5 in view of the arrangement of constituents, their detailed descriptions are eliminated because of their similarity in function.

Noted, in the deposit apparatus of Fig. 5, a ceramic heater structure having a built-in heater is employed as a mount table 1104. In case of the ceramic heater structure having a built-in heater, it is possible to integrate the ceramic mount table 1104 with the ceramic supporting part 1202 of the supporting structure 1200. However, even if adopting such an integrated structure, it goes without saying that the substrate heating apparatus of the present invention is applicable to the integrated structure on condition of providing the supporting part 1202 and the sealing part 1204 of the supporting structure 1200 in different bodies.

### (3rd. Example)

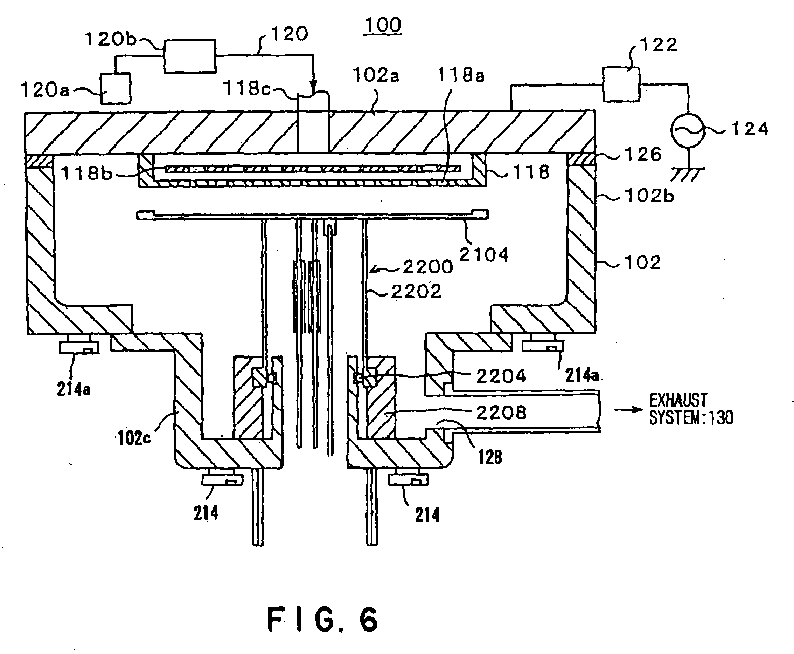

Next, the substrate heating apparatus in accordance with a third example, which is not an embodiment of the present invention will be described with reference to Fig. 6. Note, in this example, elements similar to those of the substrate heating apparatus of Figs. 1 to 4 in terms of function and constitution are indicated with the same reference numerals respectively and their overlapping descriptions are eliminated.

The deposit apparatus shown in Fig. 6 has a simple structure in comparison with the deposit apparatuses of Figs. 1 and 5. Similarly to the apparatus of Fig. 5, the interior of the supporting part 2202 is opened to the atmosphere. Further, when the temperature of a mount table 2104 is not relatively high, a temperature is not raised in the vicinity of the sealing part on the lower side of a supporting structure 2200. Then, it is possible to seal a supporting part 2202 supporting the mount table 2104 to the processing vessel 102 by sealing means having a low heat resistance, such as O-ring, directly.

Further, it is possible to constitute the supporting structure by a heat insulating material 2208 that brings the supporting part 2202 and the processing vessel 102 into a thermal-flow condition through a sealing part 2204.

For example, in case of a heating process being not very high, in other words, in case that a high heat-resistance is not required for the sealing part of the substrate supporting structure, it is possible to apply the above-mentioned structure to the case suitably.

Also in this embodiment, the Peltier element 214 is interposed on the atmospheric side of the bottom part 102c of the processing vessel 102 and the Peltier element 214a is arranged on the lower part of the processing vessel 102. Thus, by heating the bottom part 102 of the processing vessel 102 and also the lower part of the processing vessel 102 and maintaining their temperatures within a range from 100 to 200 °C, preferably, from 150 to 180 °C, the substrate heating apparatus is adapted so as not to cause separation of reaction by-product, such as NH₄Cl, and liquefaction of reaction gas.

Again, reference numeral 128 denotes an exhaust port. The exhaust system 130 as shown in Fig. 4 is connected with the exhaust port 128.

### (4th. Example)

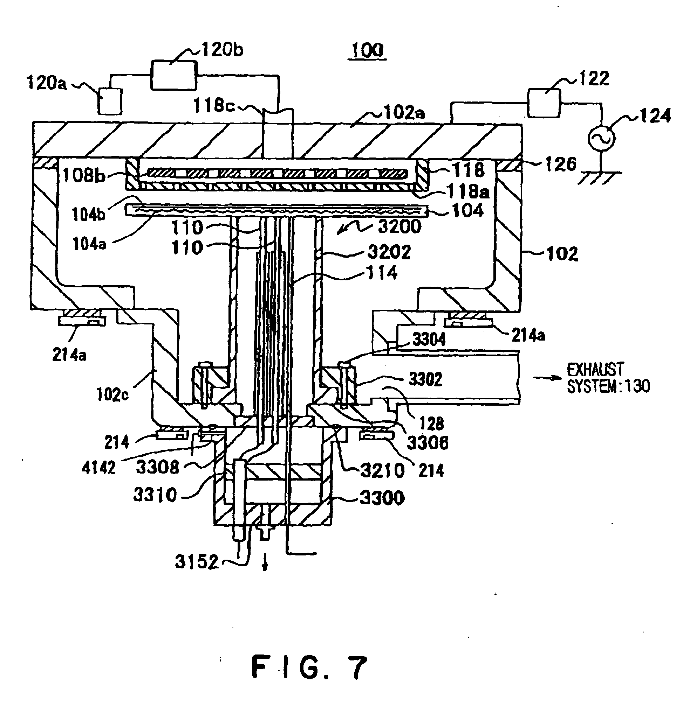

Next, the substrate heating apparatus in accordance with a fourth example, which is an embodiment of the present invention will be described with reference to Fig. 7. Note, in this embodiment, elements similar to those of the substrate heating apparatus of Figs. 1 to 6 in terms of function and constitution are indicated with the same reference numerals respectively and their overlapping descriptions are eliminated.

The difference between the substrate heating apparatus of Fig. 1 and the substrate heating apparatus of Fig. 5 resides in the supporting structures 200, 3200. In the substrate heating apparatus of Fig. 1, the sealing part 204 of the supporting structure 200 is arranged so as to surround the outside of the supporting part 202. Further, the interior of the supporting part 202 is sealed to the processing vessel 102 by the joint part 206 that joins the supporting part 202 to the sealing part 204 in an airtight manner.

While, in the substrate heating apparatus of Fig. 7, the supporting structure 3200 has a supporting part 3202 covered, in a lower part thereof, with a fixing member (clamp) 3302 made of e.g. aluminum. The lower part of the supporting part 3202 is fixed and supported on an outer wall of the lower part of the processing vessel 102 by means of screws 3304. A contact part 3306 between the supporting part 3202 and the processing vessel 102 is not sealed up in an airtight manner while there exists a surface contact therebetween.

The lower part of the supporting structure 3200 has two pieces of insulating members 3308, 3310 surrounded by an airtight casing 3300 for sealing up a lower opening of the processing vessel 102. Although the airtight casing 3300 in the illustrated example is in the form of a column opening at its top part, the casing may be shaped to be a flat plate in the modification.

The joint part between the airtight casing 3300 and the processing vessel 102 is equipped with a sealing member 3210, such as O-ring, that seals up the interior of the processing vessel 102 and the interior of the supporting part 3202 in an airtight manner from the atmosphere. The lower part of the airtight casing 3300 allows the power lines 110 and the thermo couple 114 to be drawn out while keeping the interior in an airtight condition. Further, the casing is provided, in the lower part, with an exhaust port 3152 which is connected to an exhaust system (not shown) to exhaust the interior of the supporting part 3202 to a desired degree of vacuum.

As mentioned above, by keeping the interior of the supporting part 3203 forming a vacuum, it is possible to prevent the power lines 110, the thermo couple 114, etc. from being oxidized thereby allowing the temperature of the mount table 104 to be controlled continuously and precisely. Additionally, it is possible to reduce a heat transfer thereby allowing the length of the supporting part 3200 to be reduced and also possible to decrease a heat capacity required to heating means of the apparatus. Further, since the sealing member 3210 is arranged outside the processing vessel 102, the member 3210 is not subjected to a heat transfer from the mount table 104. Therefore, for the sealing member, it is possible to employ a member (e.g. O-ring) having a low heat-resistant temperature in comparison with the arrangement of the sealing member inside the processing vessel 102. Under a situation where the temperature of the mount table 104 exceeds e.g. 300 °C, the thermo couple 114 may be replaced by a radiation thermometer having a rod of e.g. quartz, sapphire or the like, for the control of temperature. Alternatively, the using of a thermo couple together with a radiation thermometer would allow a temperature to be controlled more precisely.

Again, the casing 3300 is provided with a purge-gas introducing hole 4142 that allows the interior of the casing 3300 and the interior of the supporting part 3202 to be supplied with a purge gas, for example, nitrogen, argon or the like. When introducing the purge gas into the supporting part 3202, it is desirable, in advance of the introduction, to exhaust the interior of the supporting part 4202 through the exhaust port 3152 in evacuation, thereby establishing a predetermined degree of vacuum.

As mentioned above, by introducing the purge gas into the supporting part 3202 upon the establishment of a predetermined degree of vacuum in the interior of the supporting part 3202, it is possible to prevent the power lines 110, the thermo couple 114, etc. from being oxidized, whereby the temperature of the mount table 104 can be controlled precisely.

Also in this embodiment, the Peltier element 214 is interposed on the atmospheric side of the bottom part 102c of the processing vessel 102 and the Peltier element 214a is arranged on the lower part of the processing vessel 102. Thus, by heating the bottom part 102c of the processing vessel 102 and also the lower part of the processing vessel 102 and maintaining their temperatures within a range from 100 °C to 200 °C, preferably, from 150 °C to 180 °C, the substrate heating apparatus is adapted so as not to cause separation of reaction by-product, such as NH₄Cl, and liquefaction of reaction gas.

Again, reference numeral 128 denotes an exhaust port. The exhaust system 130 as shown in Fig. 4 is connected with the exhaust port 128.

Further, the mount table 104 has a heating wire 104a embedded therein. Above the heating wire 104a, a lower electrode 104b is also embedded in the table 104. Here, the heating wire 104a is used for plasma CVD, etching and also in a heating CVD apparatus. In a plasma apparatus, the lower electrode 104b is embedded in the surface of the mount table 104 on the upside of the heating wire 104a. A bias is applied to the electrode to carry out etching or film deposition. In etching, the embedding of the heating wire is effective for the improvement of etching rate. In film deposition, it is effective for the improvement of step coverage. The lower electrode 104b is provided with mesh structure and made of conductive material, for example, Cu, Ti, etc.

### (5th. Example)

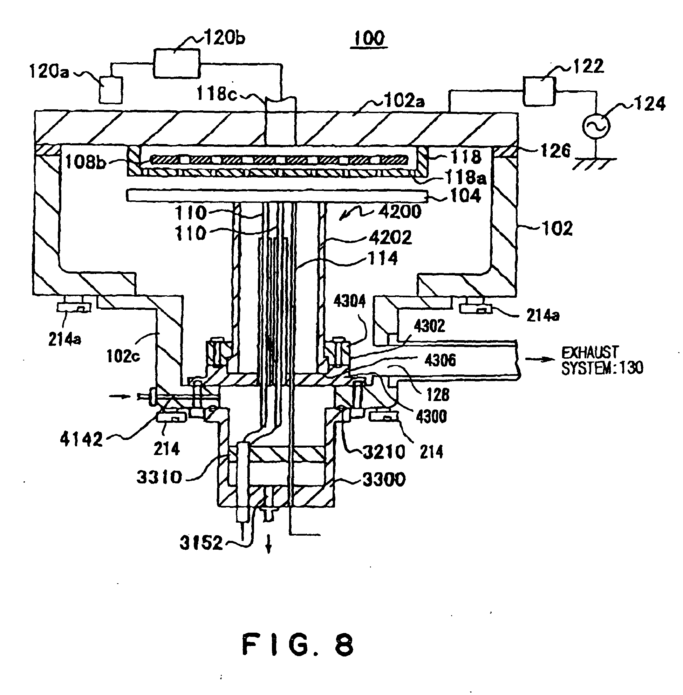

Next, the substrate heating apparatus in accordance with a fifth example, which is an embodiment of the present invention will be described with reference to Fig. 8. Note, in this embodiment, elements similar to those of the substrate heating apparatus of Figs. 1 to 7 in terms of function and constitution are indicated with the same reference numerals respectively and their overlapping descriptions are eliminated.

The difference between the substrate heating apparatus of Fig. 7 and the substrate heating apparatus of Fig. 8 resides in the supporting structures 3200, 4200. In the substrate heating apparatus of Fig. 7, the supporting structure 3200 has the supporting part 3202 covered, in a lower part thereof, with the fixing member. The lower part of the supporting part 3202 is fixed to the outer wall of the lower part of the processing vessel 102 by means of the screws 3304. The contact part 3306 between the supporting part 3202 and the processing vessel 102 is not sealed up in an airtight manner, providing a surface contact.

On the other hand, in the substrate heating apparatus of Fig. 8, the lower part of a supporting part 4202 is covered with a fixing member (clamp) 4302 formed by e.g. aluminum. Further, a supporting table 4300 of e.g. aluminum is arranged on the lower part of the fixing member 4302. The fixing member 4302 is fixed to the supporting table 4300 by means of screws 4304, thereby supporting the supporting part 4202. By arranging the supporting table 4300, it becomes possible to fix the supporting table 4300 from the side of atmosphere. Thus, since there is no need to unscrew the screws 4304 in detaching, it is possible to detach the mount table 104 and the fixing member 4302 with ease.

Although the insulating plate 3308 is arranged in the lower part of the processing vessel 102 in the example of Fig. 7, the example of Fig. 8 is provided with no insulating plate but the insulating plate 3308 only. The arrangement where the airtight plate 3300 is arranged in the lower part of the processing vessel 102 to exhaust the interior of the supporting structure 4300 through the exhaust port 3152 is substantially the same as the example of Fig. 7. Although the airtight casing 3300 is in the form of a column opening at its upper part in the shown example, the casing may be shaped to be a flat plate.

The joint part between the airtight casing 3300 and the processing vessel 102 is equipped with the sealing member 3210, such as O-ring, that seals up the interior of the processing vessel 102 and the interior of the supporting part 3202 in an airtight manner from the atmosphere. The lower part of the airtight casing 3300 allows the power lines 110 and the thermo couple 114 to be drawn out while keeping the interior in an airtight condition.

The processing vessel 102 is provided, in the lower part, with the purge-gas introducing holes 4142 that allows the interior of the airtight casing 3300 and the interior of the supporting part 4202 to be supplied with a purge gas, for example, nitrogen, Ar or the like. When introducing the purge gas into the supporting part 4202, it is desirable, in advance of the introduction, to exhaust the interior of the supporting part 4202 through the exhaust port 3152 in evacuation, thereby establishing a predetermined degree of vacuum.

As mentioned above, by introducing the purge gas into the supporting part 4202 upon the establishment of a predetermined degree of vacuum in the interior of the part 4202, it is possible to prevent the power lines 110, the thermo couple 114, etc. from being oxidized, whereby the temperature of the mount table 104 can be controlled precisely. Additionally, it is possible to reduce a heat transfer thereby allowing the length of the supporting part 4202 to be reduced and also possible to decrease a heat capacity required to heating means of the apparatus. Further, even if the supporting part 4202 is shortened, the member 3210 is not subjected to a heat transfer from the mount table 104 since the sealing member 3210 is arranged outside the processing vessel 102. Therefore, for the sealing member, it is possible to employ a member (e.g. O-ring) having a low heat-resistant temperature in comparison with the arrangement of the sealing member inside the processing vessel 102. Under a situation where the temperature of the mount table 104 exceeds e.g. 300 °C, the thermo couple 114 may be replaced by a radiation thermometer having a rod of e.g. quartz, sapphire or the like, for the control of temperature. Alternatively, the using of a thermo couple together with a radiation thermometer would allow a temperature to be controlled more precisely.

Also in this embodiment, the Peltier element 214 is interposed on the atmospheric side of the bottom part 102c of the processing vessel 102 and the Peltier element 214a is arranged on the lower part of the processing vessel 102. Thus, by heating the bottom part 102c of the processing vessel 102 and also the lower part of the processing vessel 102 and maintaining their temperatures within a range from 100 °C to 200 °C, preferably, from 150 °C to 180 °C, the substrate heating apparatus is adapted so as not to cause separation of reaction by-product, such as NH₄Cl, and liquefaction of reaction gas.

Again, reference numeral 128 denotes an exhaust port. The exhaust system 130 as shown in Fig. 4 is connected with the exhaust port 128.

### (6th. Example)

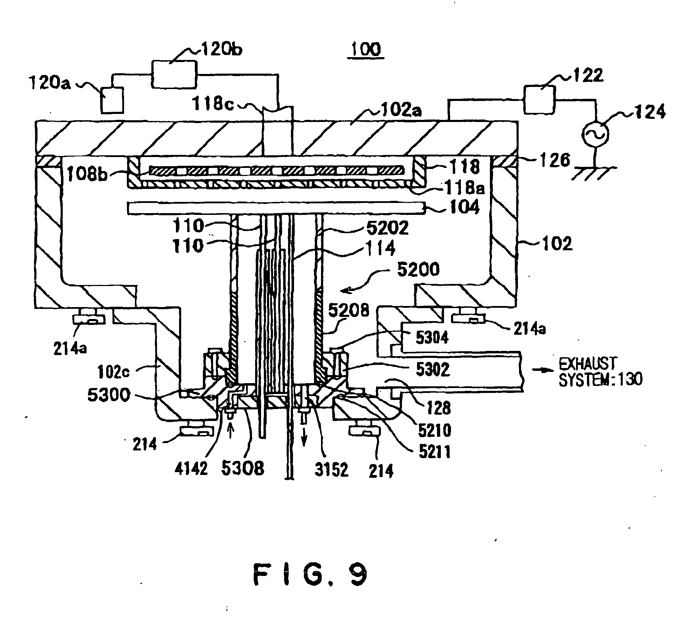

Next, the substrate heating apparatus in accordance with a sixth example, which is an embodiment of the present invention will be described with reference to Fig. 9. Note, in this embodiment, elements similar to those of the substrate heating apparatus of Figs. 1 to 8 in terms of function and constitution are indicated with the same reference numerals respectively and their overlapping descriptions are eliminated.

The difference between the substrate heating apparatus of Fig. 8 and the substrate heating apparatus of Fig. 9 resides in the supporting structures 3200, 5200. In the substrate heating apparatus of Fig. 8, the supporting part 4202 is formed by ceramics, for example, Al₂O₃, AlN, etc. While, the supporting structure 5200 has a heat insulating material 5208 arranged under a supporting part 5202 and joined thereto by means of glass fusion welding etc. The heat insulating material 5208 is formed by, for example, glass heat insulating material, silicon-content heat insulating material or the like.

In the embodiment of Fig. 8, it is noted that the fixing member 4302 is arranged below the lower part of the supporting part 4202 and further the supporting table 4300 of e.g. aluminum is arranged under the member 4302. Thus, the supporting part 4202 is supported by fixing the fixing member 4302 to the supporting table 4300 by means of the screws 4304. Further, the sealing member 3210 is arranged outside the processing vessel 102.

On the other hand, in the embodiment of Fig. 9, a fixing member 5302 is arranged at the lower part of a heat insulating material 5208 and further, a supporting table 5300 of e.g. aluminum is arranged under the member 5302. Thus, the supporting part 5202 and the heat insulating material 5208 are supported by fixing the fixing member 5302 to the supporting table 5300 by means of screws 5304. Further, there are arranged a sealing member 5210 at the joint part between the heat insulating material 5208 and the supporting table 5300 and another sealing member 5211 at the joint part between the processing vessel 102 and the supporting table 5300, so that the interior of the processing vessel 102 is sealed up from the atmosphere and the interior of the supporting structure 5200 in an airtight manner due to these sealing members 5210, 5211. Although the supporting table 5300 is provided, in its lower part, with an insulating member 5308 made of e.g. ceramics and the interior of the supporting structure 5300 communicates with the outside of the apparatus, it is possible to block off heat radiation from the mount table 104 toward the outside of the processing vessel 102.

As mentioned above, owing to the provision of the heat insulating material 5208 in the lower part of the supporting structure 5200, it is possible to prevent heat escape from the mount table 104 effectively, thereby making sure of the uniformity in temperature. Additionally, it is possible to shorten the supporting part 5202 and the heat insulating material 5208, allowing a heat capacity required for the heating means of the apparatus to be reduced. Additionally owing to the provision of the heat insulating material 5208, it is possible to employ a member having a low heat resistance for the sealing member, whereby an element, such as O-ring, can be employed. Under a situation where the temperature of the mount table 104 exceeds e.g. 300 °C, the thermo couple 114 may be replaced by a radiation thermometer having a rod of e.g. quartz, sapphire or the like, for the control of temperature. Alternatively, the using of a thermo couple together with a radiation thermometer would allow a temperature to be controlled more precisely.

The supporting structure 5300 is provided with the purge-gas introducing hole 4142 that allows the interior of the supporting part 5202 to be supplied with a purge gas, for example, nitrogen, Ar or the like. When introducing the purge gas into the supporting part 5202, it is desirable, in advance of the introduction, to exhaust the interior of the supporting part 5202 through the exhaust port 3152 in evacuation, thereby establishing a predetermined degree of vacuum. As mentioned above, by introducing the purge gas into the supporting part 5202 upon the establishment of a predetermined degree of vacuum in the interior of the part 5202, it is possible to prevent the power lines 110, the thermo couple 114, etc. from being oxidized, whereby the temperature of the mount table 104 can be controlled precisely.

Also in this embodiment, the Peltier element 214 is interposed on the atmospheric side of the bottom part 102c of the processing vessel 102 and the Peltier element 214a is arranged on the lower part of the processing vessel 102. Thus, by heating the bottom part 102c of the processing vessel 102 and also the lower part of the processing vessel 102 and maintaining their temperatures within a range from 100 °C to 200 °C, preferably, from 150 °C to 180 °C, the substrate heating apparatus is adapted so as not to cause separation of reaction by-product, such as NH₄Cl, and liquefaction of reaction gas.

Again, reference numeral 128 denotes an exhaust port. The exhaust system 130 as shown in Fig. 4 is connected with the exhaust port 128.

Note, in common with the fourth to sixth embodiments, the processing vessel of the deposit apparatus has a bucket part formed on the bottom of the vessel, as shown in Figs. 7 to 9. Nevertheless, the processing vessel of the invention is not limited to the above vessel only and therefore, there may be adopted a normal barrel-shaped vessel as shown in Fig. 5.

### (7th. Example)

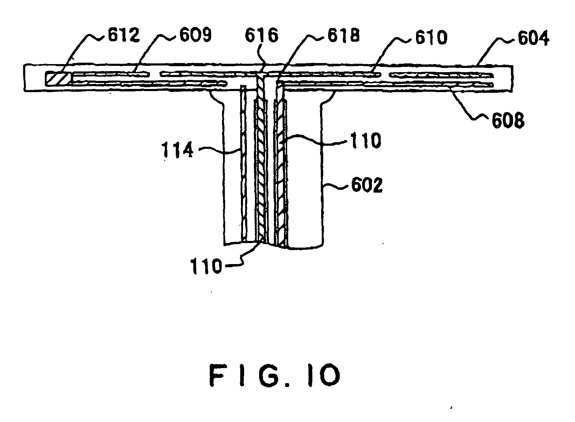

Next, the substrate heating apparatus in accordance with a seventh example, which is not an embodiment of the present invention will be described with reference to Figs. 10, 11 and 12. Note, in this embodiment, elements similar to those of the substrate heating apparatus of Figs. 1 to 8 in terms of function and constitution are indicated with the same reference numerals respectively and their overlapping descriptions are eliminated.

In the first to sixth embodiments, the characteristic part resides in the supporting structure of the apparatus. While, in this embodiment, the characteristic part resides in the constitution of a heater as the heating means of the mount table.

In prior art, a heater is embedded in a disk-shaped mount table made of e.g. ceramics and, at the center and the marginal part of the mount table, the heater has respective connecting portions for connection with power lines connected with a power source respectively. Further, the heater is formed by two parts of a resistance heating element in the form of a volute extending from the margin of the mount table toward the center in top view and another resistance heating element in the form of a volute extending from the center of the mount table toward the margin.

However, since the power lines have to be connected to the center of the table and the margin directly, the degree of freedom in the pattern of heater is so suppressed that it is difficult to realize the thermal uniformity pattern to heat an object to be processed uniformly.

Fig. 10 is a schematic sectional view of a mount table 604 of this embodiment. As shown in Fig. 10, according to the substrate heating apparatus of this embodiment, a heater embedded in the mount table 604 supported by a supporting part 602 comprises an outer heater 609 and an inner heater 610 both of which site a common wiring 608 thereunder, thereby providing a bilayer structure.

In the power lines 110 installed in the supporting part 602, one wire is connected to part of the common wiring 608 at a connecting part 619, while another wire is connected to the inner heater 610 at a connecting part 616. The outer heater 609 is connected to the common wiring 608 at a connecting part 612 in the marginal part of the table. The heaters 609, 610 forming the resistance heating elements embedded in the mount table 604 are together formed from W, Mo, etc.

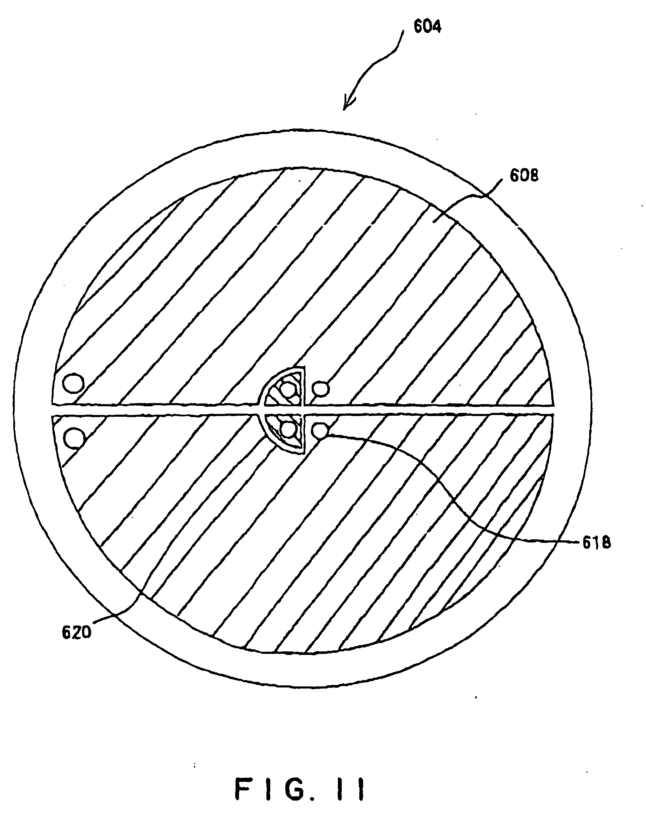

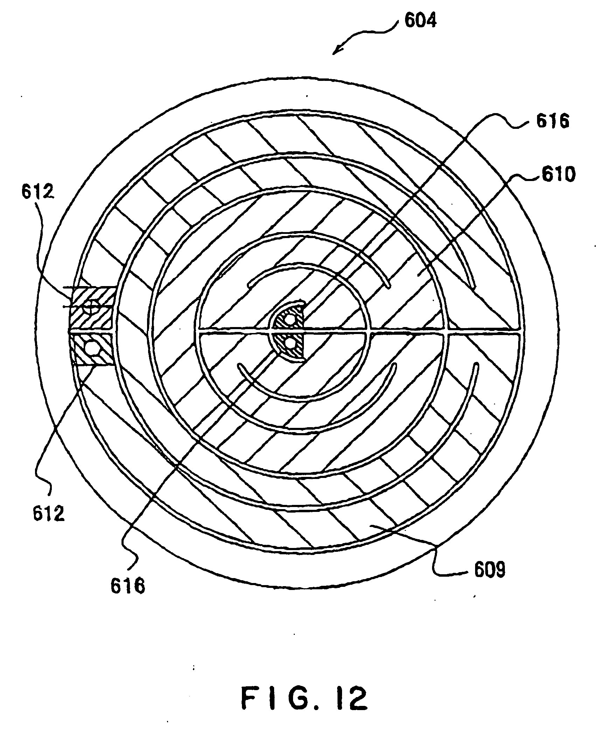

Fig. 11 is a schematic plan view showing the common wiring 608. Fig. 12 is a schematic plan view showing the outer heater 609 and the inner heater 610. As shown in Fig. 11, the common wiring 608 is arranged on the lower side of the mount table 604 in the illustrated example and also shaped in the form of a general half disk. The common wiring 608 is provided, at a center thereof, with a wiring part 620 for the power line 110 connected with the inner heater 610. As shown in Fig. 12, the inner heater 610 forms a concentric pattern and is supplied with an electric power through the connecting part 616. The outer heater 609 is arranged in the periphery of the inner heater 610 to form a concentric pattern and is supplied with an electric power through the connecting part 612.

As mentioned above, since the half-disk shaped common wiring 608 is arranged beneath the bilayer structure, the restriction in arranging the connecting parts is eliminated to broaden the degree of freedom in the heater pattern. Consequently, as the thermal uniformity pattern can be realized, it is possible to perform the processing on an object to be processed uniformly.

Note, the mount table 604 of this embodiment is applicable in combination with any one of the supporting structures 200, 1200, 2200, 3200, 4200, 5200 in the first to sixth embodiments.

### (8th. Example)

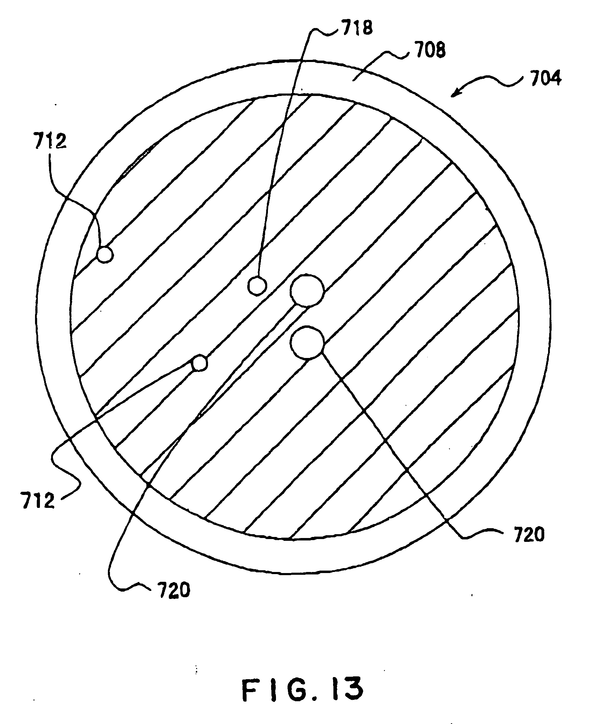

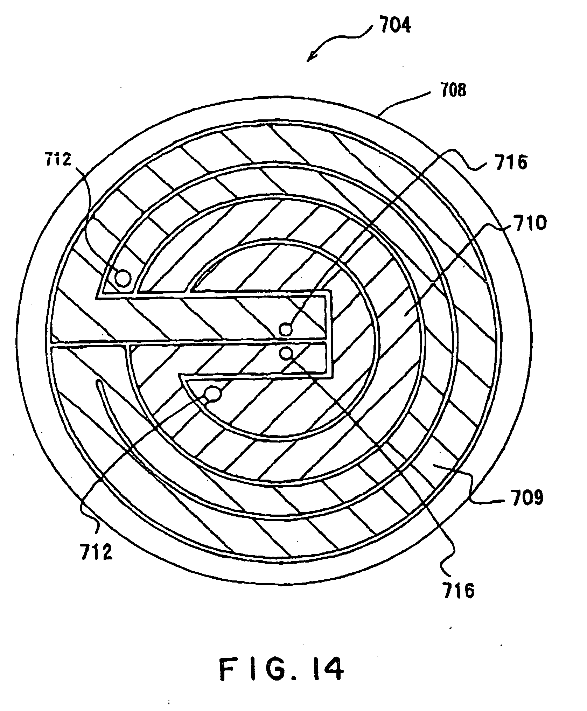

Next, the substrate heating apparatus in accordance with a eighth example, which is not an embodiment of the present invention will be described with reference to Figs. 13 and 14. Note, in this embodiment, elements similar to those of the substrate heating apparatus of Figs. 1 to 12 in terms of function and constitution are indicated with the same reference numerals respectively and their overlapping descriptions are eliminated.

In the first to sixth embodiments, the characteristic part resides in the supporting structure of the apparatus. In this embodiment, as similar to the seventh embodiment, the characteristic part resides in the constitution of a heater as the heating means of the mount table.

According to the substrate heating apparatus of this embodiment, a heater embedded in a mount table 704 replaceable for the mount table 604 of the seventh embodiment comprises an outer heater 709 and an inner heater 710 both of which site a common wiring 708 thereunder, thereby providing a bilayer structure. Fig. 13 is a schematic plan view showing the common wiring 708. Fig. 14 is a schematic plan view showing the outer heater 709 and the inner heater 710.

According to this embodiment, in the power lines 110 installed in the supporting part 602, one wire is connected to part of the common wiring 708 at a connecting part 718, while another wire is connected to the outer heater 709 and the inner heater 710 at respective connecting parts 716 through a wiring part 720 at the center of the common wiring 708. Further, the outer heater 709 is connected to the common wiring 708 at a connecting part 712 in the outer circumferentical part of the table, while the inner heater 710 is connected to the common wiring 708 at another connecting part 712 in the intermediate circumferentical part of the table. The heaters 709, 710 forming the resistance heating elements embedded in the mount table 704 are together formed from W, Mo, etc.

As shown in Fig. 13, the common wiring 708 is arranged on the lower side of the mount table 704 as similar to the common wiring 608 of the seventh embodiment and also shaped in the form of a general half disk. The common wiring 708 is provided, at a center thereof, with wiring parts 720 for the power lines 110 connected with the outer heater 720 and the inner heater 710. As shown in Fig. 14, the inner heater 710 forms a straight pattern at its central part and a concentric pattern at the other part and is supplied with an electric power through the connecting parts 712, 716. The outer heater 709, which is a concentric heater with a straight part extending from the center to the peripheral part, is arranged outside the inner heater 710 and is supplied with an electric power through the connecting parts 712, 716.

As mentioned above, since the generally-disk shaped common wiring 708 is arranged beneath the bilayer structure, the restriction in arranging the connecting parts is eliminated to broaden the degree of freedom in the heater pattern. Consequently, as the soaking pattern can be realized, it is possible to perform the processing on an object to be processed uniformly.

Note, the mount table 704 of this embodiment is applicable in combination with any one of the supporting structures 200, 1200, 2200, 3200, 4200, 5200 in the first to sixth embodiments.

Hitherto, referring to the attached drawings, the substrate heating apparatus of the present invention has been described by way of the applications to the deposit apparatus. However, the present invention is not limited to those examples. For those skilled in the art, it is obvious that various changes or modifications may be made to the present invention within the scope of technical spirit in the claims and it will be understood that these variations are included in the technical scope of the present invention.

For example, although the present invention has been described by way of an example of the application of the substrate heating apparatus to a deposit apparatus, the present invention is not limited to the above example only. It goes without saying that the substrate heating apparatus of the invention is applicable for various purposes each adopting a mechanism for heating a substrate mounted on a mount table having heating means, in a processing vessel.

Although a semiconductor wafer is used as the substrate to be processed in the above-mentioned embodiments, the present invention is not limited to this example only and therefore, a LCD substrate or the like may be adopted as the substrate to be processed. Alternatively, the present invention is applicable to an object adopting the structure where the other layer is formed on the substrate.

As mentioned above, in the substrate heating apparatus of the present invention, the supporting structure for the mount table is divided into constituents functionally and further, the resultant constituents are formed by different materials respectively. That is, the supporting structure of the invention is formed by the supporting part made of the first material to support the mount table, the sealing part made of the second material different from the first material in terms of heat conductivity to seal the supporting part and the processing vessel and the joint part joining the supporting part to the sealing part in an airtight manner.

With the constitution mentioned above, the appropriate selection of the first material and the second material of different heat conductivities allows a heat gradient between the upper part and the lower part of the supporting structure of the mount table to be reduced. Consequently, even if there is a great difference in temperature between the upper part and the lower part of the supporting structure of the mount table, it is possible to shorten the supporting structure of the mount table.

## Claims

1. A substrate heating apparatus comprising:
a processing vessel (102);
a mount table (104) arranged in the processing vessel (102) to mount a substrate thereon, the mount table having a heater (108) embedded therein to heat the substrate; and
a cylindrical supporting part (202, 4202) arranged in the processing vessel (102), the cylindrical supporting part (202, 4202) having one end positioned in the processing vessel and another end fixing the mount table (104), to allow for heating and processing a wafer on the mount table (104), wherein
the processing vessel (102) has an opening,
an opening margin is provided with a cover member (3300) for closing the opening thereof, wherein the cover member (3300) and the opening margin are sealed with each other in an airtight manner, **characterized in that**
the supporting part (202) is fixed to the opening margin of the opening of the processing vessel in a manner of surface contact while communicating the cylindrical interior of the supporting part (202, 4202) with the opening of the processing vessel.

2. A substrate heating apparatus as claimed in claim 1, wherein the supporting part (4202) is fixed to the opening margin via a supporting table (4300),
wherein the supporting table (4300) is fixed to the opening margin and the supporting part (4202) is fixed to the supporting table (4300), wherein a lower part of the supporting part (4202) is covered with a fixing member (4302), which is fixed to the supporting table (4300) by means of screws.

3. A substrate heating apparatus as claimed in Claim 1, wherein a cable (110) having an end connected to the heater (108) in the mount table (104) and another end wired to the outside through the cover member is arranged in the cylindrical supporting part (202), and the cable's part passing through the cover member is sealed in an airtight manner.

4. A substrate heating apparatus as claimed in Claim 1, wherein
the processing vessel (102) includes a bucket part (102c) formed on the bottom of the vessel,
the bucket part (102c) being provided with an exhaust port (128), and
the supporting part (202, 4202) is fixed to the bucket part (102c).

5. A substrate heating apparatus as claimed in Claim 4, wherein the processing vessel opening is formed in the bucket part (102c).

6. A substrate heating apparatus as claimed in Claim 1, further comprising purging means (140) for supplying the interior of the supporting part (202) with inert gas.

7. A substrate heating apparatus as claimed in Claim 1, wherein a sealing part (204) between the supporting part (202) and the processing vessel (102) is deformable due to heat stress.

8. A substrate heating apparatus as claimed in Claim 1, wherein a heat insulating material (208) is interposed between the supporting part (202) and the processing vessel (102).

9. A substrate heating apparatus as claimed in Claim 8, wherein the length of the supporting part (202) is defined less than 270 mm.

10. A substrate heating apparatus as claimed in Claim 1, wherein the supporting part (202) and the processing vessel (102) are sealed by an O-ring.

11. A substrate heating apparatus as claimed in Claim 1, wherein exhausting means (130) is arranged to exhaust the interior of the supporting part (202) to a vacuum.

12. A substrate heating apparatus as claimed in Claim 1, wherein power supplying means (110, 112) for the heating means (108) is provided in the supporting part (202), and the processing vessel (102) is provided, in a bottom thereof, with an exhaust port (128) for exhausting the interior of the processing vessel (102), and purging means that purges the interior of the supporting part (202).

13. A substrate heating apparatus as claimed in Claim 1, wherein the supporting part (202) is formed by ceramics.

14. A substrate heating apparatus as claimed in Claim 13, wherein the ceramics is either any one of AlN, Al₂O₃ and SiC or a combination thereof.

15. A substrate heating apparatus comprising:
a processing vessel (102);
a mount table (104) arranged in the processing vessel (102) to mount a substrate thereon, the mount table having a heater (108) embedded therein to heat the substrate; and
a cylindrical supporting structure (5200) arranged in the processing vessel (102), the cylindrical supporting structure (5200) having one end positioned in the processing vessel and another end fixing the mount table (104) the supporting structure (5200) having a heat insulating material (5208) arranged under a supporting part (5202), to allow for heating and processing a wafer on the mount table (104), wherein
the processing vessel (102) has an opening,
an opening margin is provided with a supporting table (5300) acting as a cover member for closing the opening thereof, the supporting table (5300) and the opening margin are sealed with each other in an airtight manner, such that the interior of the processing vessel is sealed up from the atmosphere and from the interior of the supporting part, **characterized in that**
the supporting part (5202) is fixed to the supporting table (5300),
wherein a fixing member (5302) is arranged at the lower part of the heat insulating material (5208), the supporting table (5300) is arranged under the fixing member (5302), and the supporting structure (5200) is supported by fixing the fixing member (5302) to the supporting table by means of screws (5304).

## Patentansprüche

1. Vorrichtung zum Heizen eines Substrats, welche Folgendes umfasst:
einen Verarbeitungsbehälter (102),
einen Haltetisch (104), der in dem Verarbeitungsbehälter (102) angeordnet ist, um ein Substrat darauf zu halten, wobei in dem Haltetisch eine Heizeinrichtung (108) eingebettet ist, um das Substrat zu erwärmen; und
ein zylindrisches Trageteil (202, 4202), welches in dem Verarbeitungsbehälter (102) angeordnet ist, wobei das zylindrische Trageteil (202, 4202) ein Ende aufweist, welches in dem Verarbeitungsbehälter angeordnet ist und ein weiteres Ende aufweist, welches den Haltetisch (104) befestigt, um eine Erwärmung und Verarbeitung eines Wafers auf dem Haltetisch (104) zu gestatten, wobei
der Verarbeitungsbehälter (102) eine Öffnung hat,
ein Rand der Öffnung ein Abdeckelement (3300) zum Verschließen der Öffnung aufweist, wobei das Abdeckelement (3300) und der Rand der Öffnung miteinander luftdicht abgedichtet sind, **dadurch gekennzeichnet, dass** das Trageteil (202) an dem Rand der Öffnung des Verarbeitungsbehälters flächenkontaktartig befestigt ist, während der zylindrische Innenraum des Trageteils (202, 4202) mit der Öffnung des Verarbeitungsbehälters kommuniziert.

2. Vorrichtung zum Heinzen eines Substrats nach Anspruch 1, bei der das Trageteil (4202) über einen Tragetisch (4300) an dem Öffnungsrand befestigt ist,
wobei der Tragetisch (4300) an dem Öffnungsrand befestigt ist und das Trageteil (4202) an dem Tragetisch (4300) befestigt ist, wobei ein unterer Teil des Trageteils (4202) mit einem Befestigungselement (4302) bedeckt ist, welches mit Schrauben an dem Tragetisch (4300) befestigt ist.

3. Vorrichtung zum Heizen eines Substrats nach Anspruch 1, bei dem ein Kabel (110), dessen eines Ende mit der Heizvorrichtung (108) in dem Haltetisch (104) verbunden ist und dessen anderes Ende durch das Abdeckelement nach außen geführt ist in dem zylindrischen Trageteil (202) angeordnet ist, und wobei der Teil des Kabels, welcher durch das Abdeckelement verläuft, luftdicht abgedichtet ist.

4. Vorrichtung zum Heizen eines Substrats nach Anspruch 1, bei dem der Verarbeitungsbehälter (102) einen Topfabschnitt (102c) umfasst, der auf dem Boden des Behälters ausgebildet ist,
wobei der Topfabschnitt (102c) mit einem Auslass-Port (128) versehen ist und das Trageteil (202, 4202) an dem Topfabschnitt (102c) befestigt ist.

5. Vorrichtung zum Heizen eines Substrats nach Anspruch 4, bei dem die Öffnung des Verarbeitungsbehälters in dem Topfabschnitt (102c) ausgebildet ist.

6. Vorrichtung zum Heizen eines Substrats nach Anspruch 1, welches ferner Mittel (140) zum Spülen umfasst, die geeignet sind, das Innere des Trageteils (202) mit einem inerten Gas zu versorgen.

7. Vorrichtung zum Heizen eines Substrats nach Anspruch 1, bei dem ein Dichtungsteil (204) zwischen dem Trageteil (202) und dem Verarbeitungsbehälter (102) durch Wärmebeanspruchung deformierbar ist.

8. Vorrichtung zum Heizen eines Substrats nach Anspruch 1, bei dem ein Wärmeisolierendes Material (208) zwischen dem Trageteil (202) und dem Verarbeitungsbehälter (102) angeordnet ist.

9. Vorrichtung zum Heizen eines Substrats nach Anspruch 8, bei dem die Länge des Trageteils (202) weniger als 270 mm beträgt.

10. Vorrichtung zum Heizen eines Substrats nach Anspruch 1, bei dem das Trageteil (202) und der Verarbeitungsbehälter (102) durch einen O-Ring abgedichtet sind.

11. Vorrichtung zum Heizen eines Substrats nach Anspruch 1, bei dem Entlüftungsmittel (130) vorgesehen sind, um im Inneren des Trageteils (202) ein Vakuum zu erzeugen.

12. Vorrichtung zum Heizen eines Substrats nach Anspruch 1, bei dem Leistungsversorgungsmittel (110, 112) für die Heizmittel (108) in dem Trageteil (202) vorgesehen sind und der Verarbeitungsbehälter (102) an seinem Boden mit einem Entlüftungs-Port (128) versehen ist, um das Innere des Verarbeitungsbehälters (102) luftleer zu machen, und mit Mitteln zum Spülen versehen ist, die das Innere des Trageteils (202) spülen.

13. Vorrichtung zum Heizen eines Substrats nach Anspruch 1, bei dem das Trageteil (202) aus Keramik besteht.

14. Vorrichtung zum Heizen eines Substrats nach Anspruch 13, bei dem die Keramik aus AlN, Al₂O₃, SiC oder einer Kombination derselben besteht.

15. Vorrichtung zum Heizen eines Substrats, die Folgendes umfasst:
einen Verarbeitungsbehälter (102);
einen Haltetisch (104), der in dem Verarbeitungsbehälter (102) angeordnet ist, um ein Substrat darauf zu halten,
wobei in dem Haltetisch eine Heizeinrichtung (108) eingebettet ist, um das Substrat zu erwärmen; und
eine zylindrische Tragestruktur (5200), die in dem Verarbeitungsbehälter (102) angeordnet ist, wobei die zylindrische Tragestruktur (5200) ein Ende aufweist, welches in dem Verarbeitungsbehälter angeordnet ist und ein anderes Ende aufweist, welches den Haltetisch (104) befestigt, wobei die Tragestruktur (5200) ein Wärmeisolierendes Material (5208) umfasst, welches unter einem Trageteil (5200) angeordnet ist, um das Erwärmen und Bearbeiten eines Wafers auf dem Haltetisch (104) zu gestatten, wobei der Verarbeitungsbehälter (102) eine Öffnung aufweist,
ein Öffnungsrand mit einem Tragetisch (5300) versehen ist, der als Abdeckelement zum Verschließen der Öffnung wirkt,
der Tragetisch (5300) und der Öffnungsrand miteinander luftdicht abgedichtet sind, so dass das Innere des Verarbeitungsbehälters von der Atmosphäre und dem Inneren des Trageteils abgedichtet ist, **dadurch gekennzeichnet, dass**
das Trageteil (5202) an dem Tragetisch (5300) befestigt ist, wobei ein Befestigungselement (5302) am unteren Teil des Wärmeisolierenden Materials (5208) vorgesehen ist, der Tragetisch (5300) unter dem Befestigungselement (5302) angeordnet ist und die Tragestruktur (5200) durch das Befestigen des Befestigungselementes (5302) an dem Tragetisch mit Hilfe von Schrauben (5304) gehalten wird.

## Revendications

1. Appareil de chauffage de substrat comprenant :
un récipient de traitement (102) ;
une table de montage (104) agencée dans le récipient de traitement (102) pour monter un substrat sur celle-ci, la table de montage possédant un dispositif de chauffage (108) encastré dans celle-ci pour chauffer le substrat ; et
une partie de support cylindrique (202, 4202) agencée dans le récipient de traitement (102), la partie de support cylindrique (202, 4202) possédant une extrémité positionnée dans le récipient de traitement et une autre extrémité fixant la table de montage (104), pour permettre le chauffage et le traitement d'une tranche sur la table de montage (104), dans lequel
le récipient de traitement (102) possède une ouverture,
une marge d'ouverture est pourvue d'un élément de couvercle (3300) pour fermer l'ouverture de celui-ci,
dans lequel l'élément de couvercle (3300) et la marge d'ouverture sont fermés l'un avec l'autre de façon étanche à l'air, **caractérisé en ce que**
la partie support (202) est fixée à la marge d'ouverture de l'ouverture du récipient de traitement en contact de surface tout en mettant en communication l'intérieur cylindrique de la partie de support (202, 4202) avec l'ouverture du récipient de traitement.

2. Appareil de chauffage de substrat selon la revendication 1, dans lequel la partie de support (4202) est fixée à la marge d'ouverture par l'intermédiaire d'une table de support (4300),
dans lequel la table de support (4300) est fixée à la marge d'ouverture et la partie de support (4202) est fixée à la table de support (4300),
dans lequel la partie inférieure de la partie de support (4202) est recouverte avec un élément de fixation (4302) qui est fixé à la table de support (4300) au moyen de vis.

3. Appareil de chauffage de substrat selon la revendication 1, dans lequel un câble (110) possédant une extrémité connectée au dispositif de chauffage (108) dans la table de montage (104) et une autre extrémité connectée à la partie extérieure à travers l'élément de couvercle est agencé dans la partie de support cylindrique (202), et la partie du câble passant à travers l'élément de couvercle est fermée de façon étanche à l'air.

4. Appareil de chauffage de substrat selon la revendication 1, dans lequel
le récipient de traitement (102) comprend une partie de réservoir (102c) formée sur le fond du récipient,
la partie de réservoir (102c) étant pourvue d'un orifice de vidage (128), et
la partie de support (202, 4202) est fixée à la partie de réservoir (102c).

5. Appareil de chauffage de substrat selon la revendication 4, dans lequel l'ouverture de récipient de traitement est formée dans la partie de réservoir (102c).

6. Appareil de chauffage de substrat selon la revendication 1, comprenant en outre des moyens de purge (140) destinés à fournir un gaz inerte à la partie intérieure de la partie de support (202).

7. Appareil de chauffage de substrat selon la revendication 1, dans lequel une partie d'étanchéité (204) entre la partie de support (202) et le récipient de traitement (102) est déformable en raison de contrainte thermique.

8. Appareil de chauffage de substrat selon la revendication 1, dans lequel un matériau isolant thermique (208) est interposé entre la partie de support (202) et le récipient de traitement (102).

9. Appareil de chauffage de substrat selon la revendication 8, dans lequel la longueur de la partie de support (202) est définie pour être inférieure à 270 mm.

10. Appareil de chauffage de substrat selon la revendication 1, dans lequel la partie de support (202) et le récipient de traitement (102) sont fermés de façon étanche par un joint torique.

11. Appareil de chauffage de substrat selon la revendication 1, dans lequel des moyens de vidage (130) sont agencés pour vider la partie intérieure de la partie de support (202) pour obtenir une dépression.

12. Appareil de chauffage de substrat selon la revendication 1, dans lequel des moyens d'alimentation en énergie électrique (110, 112) pour les moyens de chauffage (108) sont prévus dans la partie de support (202), et le récipient de traitement (102) est pourvu, dans un fond de celui-ci, d'un orifice de vidage (128) pour vider la partie intérieure du récipient de traitement (102), et de moyens de purge qui purgent la partie intérieure de la partie de support (202).

13. Appareil de chauffage de substrat selon la revendication 1, dans lequel la partie de support (202) est formée par une céramique.

14. Appareil de chauffage de substrat selon la revendication 13, dans lequel la céramique est l'un quelconque de AlN, Al₂O₃ et SiC ou une association de ceux-ci.

15. Appareil de chauffage de substrat comprenant :
un récipient de traitement (102) ;
une table de montage (104) agencée dans le récipient de traitement (102) pour monter un substrat sur celle-ci, la table de montage possédant un dispositif de chauffage (108) encastré dans celle-ci pour chauffer le substrat ; et
une structure de support cylindrique (5200) agencée dans le récipient de traitement (102), la structure de support cylindrique (5200) possédant une extrémité positionnée dans le récipient de traitement et une autre extrémité fixant la table de montage (104), la structure de support (5200) possédant un matériau isolant thermique (5208) agencé sous une partie de support (5202), pour permettre le chauffage et le traitement d'une tranche sur la table de montage (104), dans lequel
le récipient de traitement (102) possède une ouverture,
une marge d'ouverture est pourvue d'une table de support (5300) servant d'élément de couvercle pour fermer l'ouverture de celui-ci, la table de support (5300) et la marge d'ouverture sont fermées l'une avec l'autre de façon étanche à l'air, de sorte que la partie intérieure du récipient de traitement soit isolée de façon étanche de l'atmosphère et de la partie intérieure de la partie de support, **caractérisé en ce que**
la partie de support (5202) est fixée à la table de support (5300),
dans lequel un élément de fixation (5302) est agencé sur la partie inférieure du matériau isolant thermique (5208), la table de support (5300) est agencée sous l'élément de fixation (5302), et la structure de support (5200) est supportée en fixant l'élément de fixation (5302) à la table de support au moyen de vis (5304).
